# EUROPEAN PATENT SPECIFICATION

(11) **EP 2 449 864 B1**
(45) Date of publication and mention of the grant of the patent: **24.07.2013**
(21) Application number: 10740313.1
(22) Date of filing: 30.06.2010
(51) Int. Cl.: H05K 1/11, H05K 3/40, D06F 33/02

(54) **HOUSEHOLD APPLIANCE, SYSTEM AND METHOD FOR TESTING IT**
HAUSHALTSGERÄT, SYSTEM UND VERFAHREN ZUM TESTEN
APPAREIL ÉLECTROMÉNAGER ET SYSTÈME ET PROCÉDÉ POUR LE TESTER

(30) Priority: 01.07.2009 IT TO20090499
(43) Date of publication of application: 09.05.2012
(73) Proprietor: Indesit Company, S.p.A., 60044 Fabriano (AN) (IT)
(72) Inventor: MASSETANI, Angelo, I-62018 Porto Potenza Picena (MC) (IT)
(74) Representative: Santonicola, Paolo
(86) International application number: PCT/IB2010/052993
(87) International publication number: WO 2011/001389

(56) References cited:
- DE-A1-102004 057 007
- GB-A- 932 210
- US-A- 3 200 360
- US-A- 5 619 614
- US-A1- 2003 028 258
- US-A1- 2006 213 685
- US-A1- 2008 121 832
- US-B1- 6 554 654
- US-B2- 7 030 773
- MARK SHULTZ: "How to troubleshoot solid-state appliances" POPULAR MECHANICS, vol. 152, no. 2, 31 August 1979 (1979-08-31), pages 102-103, XP002600965 ISSN: 0032-4558

## Description

The present invention relates to a household appliance according to the preamble of claim 1.

The invention also relates to a system and a method for testing the household appliance, in particular before selling it. An appliance of the prior art is described in DE 10 2004 057007 A1. Further appliances of the prior art are described in US 5 916 614 A, US 2008/121832 A1.

Modem household appliances are equipped with electronic control units which control their operation depending on the user's choices (e.g. wash or drying cycles of a washing/drying machine) and on the operating conditions detected by suitable sensors (e.g. water hardness in the case of a washing/drying machine).

The control units typically comprise a printed circuit board (PCB) which accommodates a microcontroller capable of controlling the operation of the various electric and electronic components of the household appliance.

In most cases, the PCB is equipped with a connector accessible from the outside of the household appliance through an inspection opening which can be closed by means of a door or a plug.

Such a connector allows communication between an external device (e.g. a computer) and some components of the control unit, e.g. the microcontroller.

This provides easy access to the control unit for maintenance purposes, as well as for testing the household appliances before putting them up for sale.

In order to make automatic operations, such as the final testing, easier and quicker, said connector is of the type fitted with contact reeds projecting in a direction transversal to the PCB's plane.

These contact reeds allow to compensate for any tolerances in the alignment between the appliance to be tested and the test device.

Although suitable for this purpose, such connectors suffer from the typical drawback that any defects in the weld between them and the PCB may impair their proper operation.

In addition, they are subject to wear over time. When maintenance is carried out, they may suffer damage due to a technician's mistake (e.g. bending a contact reed), thus compromising the testing of the household appliance.

Furthermore, such connectors increase the cost of the household appliance.

It is the object of the present invention to overcome the drawbacks of the prior art by providing a less costly household appliance which ensures a more reliable contact between the electronic control unit and external devices.

This and other objects of the present invention are achieved through a household appliance incorporating the features set out in the appended claims, which are intended as an integral part of the present description.

The general idea at the basis of the present invention is to provide metallized portions on at least one edge of the PCB and connecting them to the microcontroller by means of communication tracks, lines or circuits, so as to allow an external device to communicate with the microcontroller by simply establishing contact with the metallized edge of the PCB.

De facto, this solution allows to eliminate the contact-reed connector, thus reducing the cost of the household appliance.

Also, this solution improves the reliability of the household appliance, because metallized parts are less subject to the typical problems suffered by the above-described connectors.

Preferably, the device used for the final testing or for checking the state of the household appliance is equipped with a contact having a cross-section which is longer than that of the metallized edge.

This solution allows to compensate for any tolerances in the alignment between the PCB and the connector of the test device.

Preferably, then, the contact of the test device is of the elastic type and comprises a spring or is flexible itself, thus compensating for any tolerances in the longitudinal alignment between the PCB and the test device.

Further objects and advantages of the present invention will become more apparent from the following detailed description and from the annexed drawings, which are supplied by way of non-limiting example, wherein:
- Fig. 1 shows a household appliance according to the present invention;
- Fig. 2 shows a detail of Fig. 1;
- Fig. 3 shows an example of a connection between the appliance of Fig. 1 and a connector of an external device;
- Fig. 4 shows a second example of a connection between the appliance of Fig. 1 and a connector of an external device;
- Fig. 5 shows a third example of a connection between the appliance of Fig. 1 and a connector of an external device.

Although the present invention is applicable in general to any type of household appliance equipped with a control board that can be interfaced to an external system for testing and/or maintenance purposes (e.g. refrigerators, ovens, dryers, television sets, etc.), in the following description the invention will be described with reference to a washing machine.

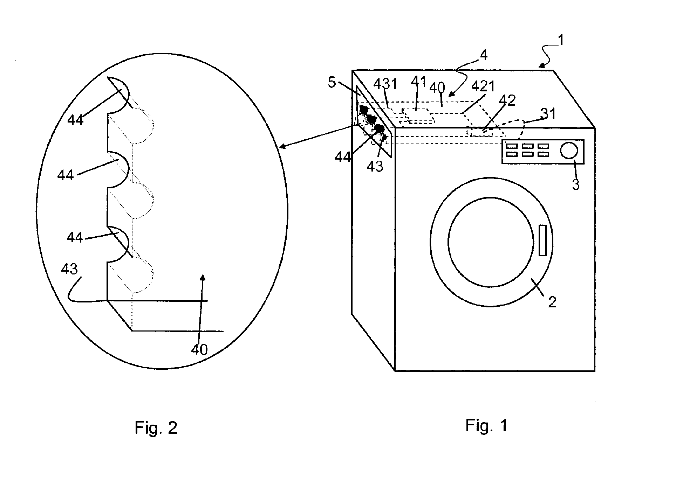

In the example of Fig. 1, the washing machine 1 has a load opening which can be closed by means of a door 2.

The user puts the laundry into a drum (not shown in Fig. 1) through the load opening and then selects a laundry wash program through a control panel 3.

The control unit 4 arranged inside the machine (which for this reason is shown by a dashed line) is connected to the control panel 3 and receives the user's commands. The control unit 4 comprises a printed circuit board (PCB) 40 on which a microcontroller 41 is installed.

The control panel 3 is connected to a connector 42 of the control unit by means of a cable 31.

Through one or more lines 421, the microcontroller receives the user's commands, selects the program to be executed, and sends the appropriate controls to the various devices of the washing machine; for example, it controls the water supply valves, the drum rotation speed, and so on.

As an alternative to the lines 421, it is conceivable to employ an interface circuit or board which handles the communications between the microcontroller 41 and the control panel 3.

As shown clearly in Fig. 2, on one edge 43 the PCB 40 has metallized portions 44 which are connected to the microcontroller 41 through lines (e.g. printed tracks) 431. The metallized portions 44, typically made of copper, may be connected to the microcontroller in a different manner as well, e.g. through electric circuits comprising other devices.

In general, therefore, it is important for the purposes of the present invention that the metallized portions are operationally connected to the microcontroller, i.e. that the signals received at the metallized portions can then be transferred (possibly after having been re-processed) to the microcontroller.

The metallized portions 44 act as a contact element for a connector of an external device, such as, for example, a machine for testing the washing machine or for controlling it during maintenance operations.

In order to promote the contact and prevent any accidental short circuits between the metallized portions, the latter are obtained inside semicylindrical surfaces open towards the edge of the PCB.

Thus, said edge takes a shape which in the electronics jargon is commonly called "castellated".

Advantageously, said metallized semicylindrical surfaces are obtained by making through holes in the PCB and preparing the edge of the latter by using the VCut technique, which is per se known to the man skilled in the art.

Preferably, the holes have a diameter smaller than or equal to 4.7 mm and greater than 1 mm.

By using the VCut technique, a V-shaped notch is made in the board at the through holes. When the two edges of the V-shaped notch are subsequently separated through a shearing operation, an edge remains on the board which has a metallization (44) on a cylindrical surface portion, the base of which is an arc having a circumference the length of which is preferably between 1/3 (one third) and 2/3 (two thirds), more preferably 1/2 (one half) of the circumference of the original hole; said portion is therefore semicylindrical.

Advantageously, the shearing operation is carried out on the PCB surface opposite to that which accommodates the tracks departing from the metallized portions 44, e.g. the tracks 431, so that the PCB shearing operation will not damage the tracks themselves or the copper ring pressed on the PCB in electric continuity with the hole metallization.

To further improve the contact at the board edge, in a preferred embodiment the metallized half-cylinder is also coated (at least partially) with a conductive material, in particular tin or solder alloy, which offers a softer contact surface than the metallized PCB.

In a preferred embodiment, said material is deposited during the process of soldering the components to the PCB, in particular during the wave soldering process.

During the wave soldering process, the solder alloy crawls up along the metallized portions 44, thus forming a softer contact surface.

The quantity of solder alloy crawling up and depositing onto the side wall of the hole depends on the solder mask laid on the PCB where the copper ring has been placed around the hole: in the limit condition of said ring being fully covered, no solder alloy will crawl up; the larger the surface of the copper ring which is left uncovered, the larger the quantity of solder alloy which will crawl up and deposit onto the hole wall. The PCB is installed inside the washing machine with its metallized edge facing an inspection opening 5, which in the example of Fig. 1 is located on one side of the machine.

The opening 5 can preferably be closed by means of a door or a plug (e.g. of the snap-on type), so that the control unit is not exposed to the outside environment.

In order to increase the contact surface, the metallized portions 44 extend over the full height of the edge, i.e. they extend from the upper surface to the lower surface of the PCB.

When testing or maintaining the household appliance, a connector fitted with one or more contact elements adapted to establish contact with the metallized portions 44 at the edge 43 is inserted into the inspection opening.

Preferably, the connector of the external device that must communicate with the control unit is provided with contact elements 45 having a contact surface 46 which is longer than the height of the edge 43.

Thus, any tolerances in the alignment between the household appliance and the external device are compensated for, which is advantageous whenever the procedures for connecting the control unit 4 to the external device are automated.

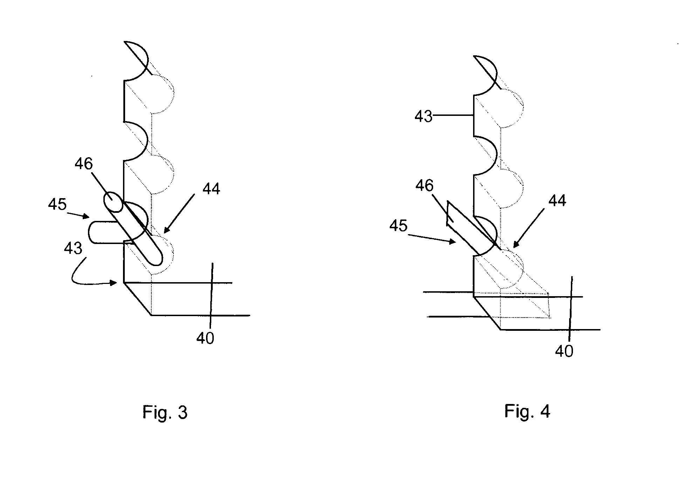

In the example of Fig. 3, the end of the connector of the external device has a T-shaped head; however, different shapes may also be employed, as shown in Fig. 4.

In the example of Fig. 4, the connector 45 has a spring-type contact obtained by means of a flexible L-shaped metal reed, which provides compensation for both height alignment errors (thanks to the length of the major side of the connector) and depth errors, due to the connector's flexibility.

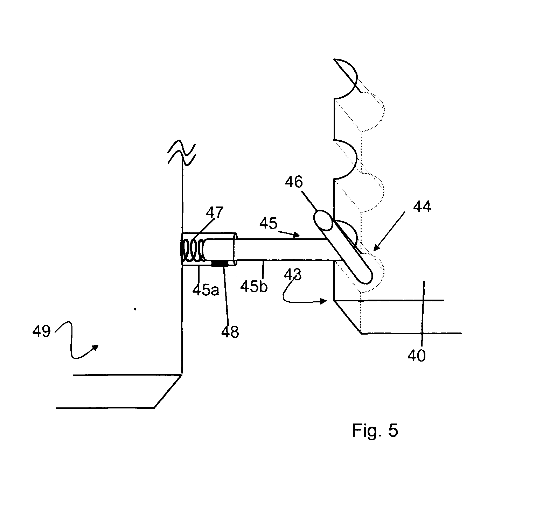

In the example of Fig. 5, the connector 45 is fitted with a spring 47 which makes it elastic and allows to compensate for any longitudinal tolerances in the alignment between the external device and the household appliance.

For this purpose, the spring 47 is inserted into a metal cylinder 45a which is telescopically coupled to a second cylinder 45b carrying the contact element 46 at its end.

Inside the cylinder 45a there are sliding contacts 48 which provide a connection to the mobile element and allow the electric signals to be transferred from the PCB to the external device 49.

It is apparent, however, that many changes may be made to the present invention by those skilled in the art without departing from the protection scope thereof as stated in the appended claims.

In fact, the control unit may consist of one or more PCBs connected to one another, and may comprise one or more microcontrollers dedicated to different functions.

In this case, depending on the electric connections established between the PCBs and the elements to be contacted by the external device, it is conceivable to provide metallized surfaces on one or more PCBs.

Alternatively, it is also conceivable to provide metallized surfaces on just a single PCB and then wire such metallized surfaces to other PCBs.

The inspection opening 5, which in the example of Fig. 1 is provided on one side of the machine, may be located in a different position or not be provided at all.

For example, the control unit may be arranged under a wall (in particular a panel) of the household appliance that can be removed easily, e.g. by means of screws.

In such a case, the testing operations are carried out when said wall has not yet been mounted to the household appliance, said wall being installed at the end of the testing process.

In this case as well, it is nonetheless preferable that the metallized portions face the opening obtained by removing said wall.

More in general, what has been stated above in regard to final testing operations is also applicable to verifying the operation of the household appliance under different conditions, e.g. when maintenance is carried out.

In this case, the household appliance is connected to a device for verifying the proper operation thereof, e.g. a dedicated test device or an electronic interface device (e.g. a notebook computer) which, when connected to the household appliance, performs a verification of the operation of the latter by exchanging information therewith.

## Claims

1. Household appliance (1) comprising an electronic control unit (4), said electronic control unit (4) comprising a printed circuit board (40) and a microcontroller (41), wherein one edge (43) of said board (40) comprises at least one metallized portion (44) operationally connected to said microcontroller (41), wherein said at least one metallized portion (44) extends over the full height of said edge (43), **characterized in that** said printed circuit board (40) is installed in said household appliance (1) with said at least one metallized portion (44) facing an inspection opening (5) obtained in a wall of said household appliance (1).

2. Appliance according to any of the preceding claims, wherein said at least one metallized portion (44) is arranged on a portion of a cylindrical surface, preferably a semicylindrical surface, open towards said edge (43).

3. Appliance according to any of the preceding claims, wherein said at least one metallized portion (44) is coated with a conductive material, preferably solder alloy.

4. System for testing a household appliance (1) comprising an electronic control unit (4), wherein a test device is adapted to be connected to the electronic control unit (4) of said household appliance (1), **characterized in that** said household appliance (1) is designed in accordance with any of claims 1 to 3, and that said test device comprises a connector (45) fitted with at least one elastic contact element (46), which is preferably longer that the height of the edge (43) that comprises said at least one metallized portion.

5. System according to claim 4, wherein said connector (45) has a contact element (46) with a T-shaped head.

6. System according to claim 4, wherein said connector (45) has a contact element (46) with an L-shaped head.

7. Method for testing a household appliance (1) equipped with an electronic control unit (4), comprising the steps of:
connecting said household appliance to a test device, and
testing said household appliance by exchanging information between said test device and said control unit,
**characterized in that** said step of connecting the household appliance (1) to the test device comprises the step of placing a connector (45) of said test device in contact with at least one metallized portion (44) provided on one edge (43) of a printed circuit board (40) of said control unit (4), said metallized portion (44) extending over the full height of said edge (43), said at least one metallized portion (44) facing an inspection opening (5) obtained in a wall of said household appliance (1).

## Patentansprüche

1. Haushaltsgerät (1), das eine elektronische Steuereinheit (4) aufweist, wobei die elektronische Steuereinheit (4) eine gedruckte Schaltplatine (40) und einen Microcontroller (41) aufweist, wobei ein Rand (43) der Platine (40) zumindest einen metallisierten Abschnitt (44) aufweist, der mit dem Microcontroller (41) betriebsmäßig verbunden ist, wobei sich der zumindest eine metallisierte Abschnitt (44) über die volle Höhe des Rands (43) erstreckt, **dadurch gekennzeichnet, dass** die gedruckte Schaltplatine (40) in dem Haushaltsgerät (1) so angebracht ist, dass der zumindest eine metallisierte Abschnitt (44) zu einer Inspektionsöffnung (5) weist, die in einer Wand des Haushaltsgeräts (1) vorgesehen ist.

2. Gerät nach einem der vorhergehenden Ansprüche, worin der zumindest eine metallisierte Abschnitt (44) an einem Abschnitt einer zylindrischen Oberfläche, bevorzugt einer halbzylindrischen Oberfläche, angeordnet ist, die sich zu dem Rand (43) hin öffnet.

3. Gerät nach einem der vorhergehenden Ansprüche, worin der zumindest eine metallisierte Abschnitt (44) mit leitfähigem Material beschichtet ist, bevorzugt Lötlegierung.

4. System zum Testen eines Haushaltsgeräts (1), das eine elektronische Steuereinheit (4) aufweist, worin eine Testvorrichtung dazu ausgelegt ist, mit der elektronischen Steuereinheit (4) des Haushaltsgeräts (1) verbunden zu werden, **dadurch gekennzeichnet, dass** das Haushaltsgerät (1) gemäß einem der Ansprüche 1 bis 3 konstruiert ist, und dass die Testvorrichtung einen Stecker (45) aufweist, der mit zumindest einem elastischen Kontaktelement (46) ausgestattet ist, das bevorzugt länger ist als die Höhe des Rands (43), der zumindest einen metallisierten Abschnitt aufweist.

5. System nach Anspruch 4, worin der Stecker (45) ein Kontaktelement (46) mit einem T-förmigen Kopf hat.

6. System nach Anspruch 4, worin der Stecker (45) ein Kontaktelement (46) mit einem L-förmigen Kontakt hat.

7. Verfahren zum Testen eines Haushaltsgeräts (1), das mit einer elektronischen Steuereinheit (4) ausgestattet ist, welches die Schritte aufweist:
Verbinden des elektrischen Haushaltsgeräts mit einer Testvorrichtung, und
Testen des Haushaltsgeräts durch Informationsaustausch zwischen der Testvorrichtung und der Steuereinheit,
**dadurch gekennzeichnet, dass** der Schritt des Verbindens des Haushaltsgeräts (1) mit der Testvorrichtung den Schritt aufweist, einen Stecker (45) der Testvorrichtung in Kontakt mit zumindest einem metallisierten Abschnitt (44) zu bringen, der an einem Rand (43) einer gedruckten Schaltplatine (40) der Steuereinheit (4) vorgesehen ist, wobei sich der metallisierte Abschnitt (44) über die volle Höhe des Rands (43) erstreckt, wobei der zumindest eine metallisierte Abschnitt (44) zu einer Inspektionsöffnung (5) weist, die in einer Wand des Haushaltsgeräts (1) vorgesehen ist.

## Revendications

1. Appareil ménager (1) comportant une unité de contrôle électronique (4), ladite unité de contrôle électronique (4) comprenant une carte à circuits imprimés (40) et un microcontrôleur (41), dans lequel une bordure (43) de ladite carte (40) comporte au moins une partie métallisée (44) connectée fonctionnellement au dit microcontrôleur (41), dans lequel ladite au moins une partie métallisée (44) s'étend sur toute la hauteur de ladite bordure (43), **caractérisé en ce que** ladite carte à circuits imprimés (40) est installée dans ledit appareil ménager (1), ladite au moins une partie métallisée (44) faisant face à une ouverture de contrôle (5) réalisée dans une paroi du dit appareil ménager (1).

2. Appareil selon l'une quelconque des revendications précédentes, dans lequel ladite, au moins une, partie métallisée (44) est disposée sur une portion d'une surface cylindrique, de préférence d'une surface semi-cylindrique, ouverte vers ladite bordure (43).

3. Appareil selon l'une quelconque des revendications précédentes, dans lequel ladite, au moins une, partie métallisée (44) est recouverte d'un matériau conducteur, de préférence d'un alliage de soudure.

4. Système pour tester un appareil ménager (1) comportant une unité de contrôle électronique (4), dans lequel un dispositif de test est adapté pour être connecté à l'unité de contrôle électronique (4) dudit appareil ménager (1), **caractérisé en ce que** ledit appareil ménager (1) est conçu selon l'une quelconque des revendications 1 à 3, et **en ce que** ledit dispositif de test comporte un connecteur (45) assemblé avec au moins un élément de contact élastique (46), lequel, de préférence, est plus long que la hauteur de la bordure (43) qui comporte ladite, au moins une, partie métallisée.

5. Système selon la revendication 4, dans lequel ledit connecteur (45) comporte un élément de contact (46) doté d'une tête configurée en forme de T.

6. Système selon la revendication 4, dans lequel ledit connecteur (45) comporte un élément de contact (46) doté d'une tête configurée en forme de L.

7. Procédé permettant de tester un appareil ménager (1) équipé d'une unité de contrôle électronique (4), comportant les étapes comprenant de :
connecter ledit appareil ménager à un dispositif de test, et
tester ledit appareil ménager par un échange d'information entre ledit dispositif de test et ladite unité de contrôle,
**caractérisé en ce que** ladite étape de connexion de l'appareil ménager (1) au dispositif de test comprend l'étape consistant à placer un connecteur (45) dudit dispositif de test en contact avec au moins une partie métallisée (44) prévue sur une bordure (43) d'une carte à circuits imprimés (40) de ladite unité de contrôle (4), ladite partie métallisée (44) s'étendant sur toute la hauteur de ladite bordure (43), ladite, au moins une, partie métallisée (44) faisant face à une ouverture de contrôle (5) réalisée dans une paroi du dit appareil ménager (1).
